Europäisches Patentamt

European Patent Office

Office européen des brevets

(11) Publication number: **0 522 525 A1**

(12) **EUROPEAN PATENT APPLICATION**

(21) Application number: **92111574.7**

(22) Date of filing: **08.07.92**

(51) Int. Cl.⁵: **H03C 1/04**, H03F 1/32, H03D 7/00

(30) Priority: **11.07.91 IT MI911927**

(43) Date of publication of application:
**13.01.93 Bulletin 93/02**

(84) Designated Contracting States:
**DE ES FR GB GR IT SE**

(71) Applicant: **SIEMENS TELECOMUNICAZIONI S.P.A.**

SS. 11 Padana Superiore Km. 158
I-20060 Cassina de Pecchi (Milano)(IT)

(72) Inventor: **Bonato, Paolo**
**P.zza Caneva, 1**
**I-20154 Milano(IT)**
Inventor: **Canzi, Fabio**
**Via Comunale per Albiate, 31**
**I-20048 Carate (MI)(IT)**

(54) **Process for compensation of AM/PM distortion of a transmitter by modulation of the local oscillator phase, and associated compensation circuit.**

(57) There is described a process and a circuit for compensation of the conversion of amplitude modulation to phase modulation (AM/PM) otherwise introduced by the amplification device in a radiofrequency amplified signal.

The circuit which actuates the process which is the object of the present invention comprises a phase shifter of the local oscillator signal which acts according to a law contrary to that with which the final amplification device modulates (distorts) due to the effect of the AM/PM conversion the radiofrequency signal phase. Said phase shifter is controlled by the envelope voltage of the intermediate frequency signal full-wave detected. The circuit also comprises a frequency mixer which converts the intermediate frequency signal to radiofrequency by using the local frequency signal present at the phase shifter output.

The circuit which is the object of the present invention is used in a microwave transmitter for modulated signals QAM operating in band K.

FIG. 1

The present invention relates to the field of amplification in radiofrequency of amplitude modulated signals. More precisely there is described a process for compensation of the distortion known as conversion of amplitude modulation to phase modulation (AM/PM), otherwise introduced by the amplification device in a radiofrequency amplified signal. The circuit which actuates said process is also described.

It is known that a nonlinear device such as for example a field effect transistor (FET) used as a power amplifier of an amplitude modulated radiofrequency signal distorts said signal and generates a multiplicity of new signals having frequency bands placed around multiple frequencies of the radiofrequency carrier.

The signals of said multiplicity are termed conversion products and it is appropriate that they be eliminated from the amplified signal because they represent a distortion thereof. Each conversion product is the result of the combined effect of two types of distortion. A first type is due to the conversion of the amplitude modulation into another amplitude modulation different from the previous one. A second type is due to conversion of the amplitude modulation into a phase modulation.

The first type of distortion is known as AM/AM distortion and is essentially tied to the nonlinear characteristic of the amplification device gain.

The second type of distortion is known as AM/PM distortion and is caused by the variations of the reactive parameters of said device.

In particular, if the amplification device is a FET it is found that an amplitude modulated signal undergoes, in addition to amplitude distortion, an undesired phase leading increasing with the height of the modulated signal envelope peak.

The nonlinearities of the entire transmissive system comprising both the transmitter and the receiver are particularly troublesome when the modulated signal to be amplified is the QAM type. Indeed, in this case, for correct demodulation, precision of the amplitude levels and phase values is essential.

The preponderant contribution to said nonlinearities of the transmissive system is due mainly to the power amplifier devices of the transmitter. Indeed, it is mainly in transmission that it is necessary to have a high-power radiofrequency signal, usually obtained by piloting the amplification devices in such a manner that they deliver maximum power. Consequently said devices must be used in zones in which their behaviour is no longer linear.

It is also known that to make full use of the output characteristic of a power device it is possible to equip the transmitter with special linearizing circuits which correct its operation under high power conditions.

A particularly widely used class of linearizers is based on the use of appropriate predistorter circuits acting on the amplitude and independently on the phase of the signal to be amplified in such a manner as to precompensate the final stage distortions.

Said linearizers produce a signal which differs from the original one in that from the signal to be amplified there are subtracted appropriate predistortion signals generated by the predistorters. The predistortion signals have an amplitude and phase curve foreseeably similar to that which will be actually introduced by the final amplification devices. Final amplification of the predistorted signal supplied by the linearizer circuit provides a distortion-free amplified signal.

Limiting the following discussion to the phase predistorters only, which more strictly represent the field in which the invention described below falls, it can be generalized that they fall into one of two categories depending on whether they predistort an intermediate frequency signal or a radiofrequency signal.

In a transmitter it is of course possible to opt for either solution because there exist both the intermediate frequency and the radiofrequency sections.

Known phase predistorters in both categories, called hereinafter simply predistorters, display however various kinds of shortcomings.

Those with intermediate frequency have a limited operative band while being easy to make. Said limits are inseparably connected to the physical law which governs frequency conversion and therefore cannot be eliminated.

Making circuits containing radiofrequency predistorters is more difficult, especially when operation takes place at high frequencies, such as those belonging to microwave K-band, but on the other hand the operative band they have can be much more extended than that of the predistorters of the above category.

The present invention obviates the above shortcomings by indicating a compensation process of the phase distortion known as conversion of amplitude modulation into phase modulation (AM/PM), otherwise introduced by an amplification device in a radiofrequency amplified signal.

The process which is the object of the present invention consists essentially of modulating the phase of a local oscillator signal by a modulation law represented by the full-wave detection envelope of an intermediate frequency signal modulated by a base band signal and using the phase modulated local oscillator signal to convert to radiofrequency the intermediate frequency signal, to obtain, by the effect of the above mentioned modulation law and the synchronism between the phase modulation and conversion operations, a radiofrequency signal also phase modulated in accordance with said modulation law and whose phase undergoes instantaneous variation equal and with contrary sign to that introduced by the radiofrequency amplification device.

Another object of the present invention is a predistorter circuit for compensation of the distortion due to conversion of amplitude modulation into phase modulation (AM/PM), provided in accordance with the above process as better described in claim 3.

The predistorter circuit which is the object of the present invention comprises a phase shifter embodied, in the nonlimiting example described below, using a FET. Since in the example described the final radiofrequency amplification device is also a FET, it follows that the same law which governs phase predistortion also governs the phase distortion introduced during radiofrequency amplification. In addition, considering that for distortion purposes both transistors are piloted by signals having the same envelope, it can readily be understood that it is possible to fully compensate the phase distortion.

The frequency converter used in the predistorter of the described embodiment is of the subharmonic type with image suppression, and therefore has the advantage of not requiring the image suppressor filter at the output. By this choice it is possible to compensate the radiofrequency signal phase by starting from a local oscillator frequency half that which would otherwise be necessary using a converter operating on the fundamental frequency. As a result there is the not negligible advantage that the local oscillator signal phase variation necessary for obtaining the desired compensation is also halved.

The process which is the object of the present invention considerably simplifies the embodiment of a predistorter for compensation of the AM/PM distortion mainly because the phase shifter circuit included in the predistorter must phase shift a monochromatic signal, a much less critical and costly operation than compensation actuated by known phase predistorters operating on the radiofrequency signal. The latter include a phase shifter circuit the making and integration of which in micromodules containing FET devices in chips is particularly costly, especially when the radiofrequency signal to be phase shifted is included in the microwave k-band.

In conclusion the predistorter obtained in accordance with the process which is the object of the present invention unites all the advantages of known predistorters and is thus free of the associated defects. Indeed, it is simple to make and possesses a broad band of operation.

Additional objects and advantages of the present invention will be made clear by the detailed description given below of an example of embodiment thereof and the annexed drawings given merely by way of nonlimiting example wherein:-

FIG. 1 shows a block diagram of a transmitter which includes the phase distortion compensation circuit in accordance with the present invention, and

FIG. 2 shows some electrical characteristics of the phase shifter block SFAS of FIG. 1.

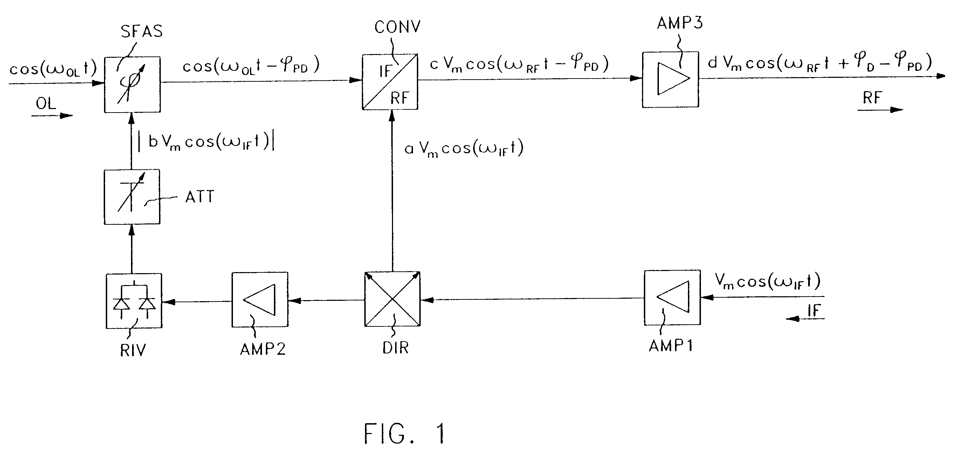

With reference to FIG. 1 there is noted a first amplifier AMP1 at whose input arrives an intermediate frequency signal IF = $V_m\cos(\omega_{IF}t)$, being $\omega_{IF}/2\pi$ = $f_{IF}$ the centre band frequency of the IF signal. The amplified signal present at the output of the block AMP1 reaches the input of the branching block DIR which distributes it to two outputs. A first output is connected to a first input of an up-frequency converter CONV while a second output is connected to the input of a second amplifier AMP2.

The amplified intermediate frequency signal present at the output of AMP2 is full-wave detected by a detector RIV and then sent to a variable attenuator ATT whose output is connected to a control input of a phase shifter block SFAS. To a signal input of the block SFAS arrives a local oscillator signal OL = $V_m\cos(\omega_{OL}t)$, being $\omega_{OL}/2\pi$ = $f_{OL}$ the frequency of the signal OL. The output of the block SFAS is connected to a second input of the converter CONV whose output is connected to the input of an amplifier block AMP3.

At the output of the amplifier AMP3 there is present a radiofrequency signal RF coming from the conversion of the IF signal.

The amplifiers AMP1 and AMP2 are ordinary intermediate frequency signal amplifiers with $f_{IF}$ on the order of 70MHz. In particular, the amplifier AMP2 has a high input impedance and low output impedance.

The block AMP3 comprises a field effect transistor of the GaAsFET type, not shown in the figure and hereinafter called FET, used as an amplification device for RF signals belonging to an operative range between 18GHz and 19GHz. Said transistor displays nonlinear behaviour at the highest power levels of the signal at its input. Consequently it distorts the amplitude and phase of the amplified signal in the manner explained above.

The block DIR can be provided like the block AMP1 by doubling the output connections of the amplifier.

The detector RIV is embodied in a known manner by means of a transformer with secondary having a central connection connected to ground and the other two ends connected to the anodes of two diodes having common cathodes respectively.

The transformation ratio is 2:1. The diodes used are Shottky SIEMENS BAS70 polarized in conduction with a current of approximately 0.5 mA to increase their sensitivity. The detector RIV can also be provided by means of a bridge of diodes, provided they are identical, i.e. obtained by a single integration process.

The variable attenuator ATT is made with a transistor in the common collector configuration having a voltage divider on the emitter for regulation of the detected signal level.

The detected signal is mathematically represented by the module of the IF signal multiplied by a constant $\underline{b}$ which keeps into account all the amplifications and attenuations which the IF signal undergoes up to the input of the block SFAS.

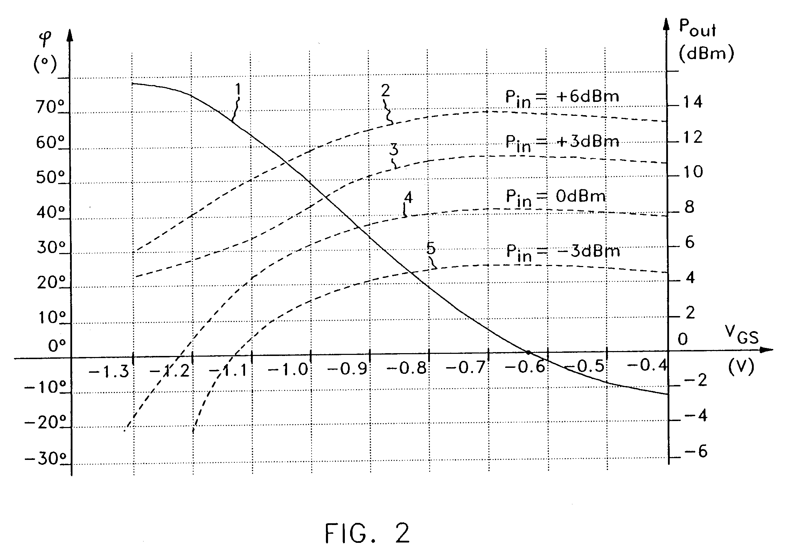

The phase shifter SFAS, excepting slight modifications available to those skilled in the art is similar to that described in a variant embodiment included in Italian patent application N. 19975 dated 9 April 1990 entitled "Predistortion linearizer for microwave power amplifiers" filed in the name of the same applicant. In said variant, as better described below in the discussion of FIG. 2, the phase shifter made use of the phase characteristic of a class A polarized GaAsFET transistor. The SFAS phase shifter also makes use of the phase characteristic of a class A polarized FET used as an amplifier to ensure to the signal OL an adequate level of power at the input of the converter CONV.

The phase shifter SFAS can however be provided by means of a purely reactive balanced network comprising two varactors as is for example the network described in the text of Italian patent application N. 19975 mentioned above.

The block CONV represents a more general type of frequency converter. In particular it can be a converter operating on the fundamental or the subharmonic and in both cases it can be of the normal or image-suppression type.

The converter used in the compensation circuit of the embodiment example is a harmonic frequency converter with image suppression. It is described in the text of Italian patent application 23219A/87 dated 3 December 1987 entitled "Improvement in an image suppression harmonic frequency converter operating in the microwave field", filed in the name of the same applicant.

All the blocks of FIG. 1 excepting AMP3 are part of the predistorter which is the object of the present invention. The block SFAS because it directly actuates predistortion; the blocks AMP1, DIR, AMP2, RIV and ATT because they are indispensible for operation of SFAS; the block CONV because in translating the IF signal to radiofrequency it simultaneously imparts the necessary phase predistortion to correct the phase characteristic of AMP3.

Operation of the predistorter of FIG. 1 can be described starting with the input signal IF which, in the nonlimiting example described, has a 47MHz band centered around an intermediate frequency $f_{IF}$ of 70MHz. Said signal is type 16 QAM originated by a PCM signal of 140Mbit/s whose pulses have rising and falling edges with 35% slope (roll-off of 0.35).

The IF signal reaches a first input of the converter CONV to be converted into radiofrequency following a first path which goes through blocks AMP1 and DIR. The amplifier AMP1 increases by a times the amplitude of the IF signal. The IF signal reaches the second input of the converter CONV through a second path which comprises in sequence the blocks AMP1, DIR, AMP2, RIV, ATT and SFAS. The delay between the two inputs of CONV due to the different length between the too paths is easily compensated by the addition of a delay block, not shown in the figure, on the first output of the block DIR.

The amplifier AMP2 couples the IF signal present at the second outlet of the branching block DIR to the input of the detector RIV. The high input inpedance of AMP2 makes it possible to avoid excessively loading the output of the block DIR, while its low output impedance allows correct control of the transformer and the diodes of the block RIV. The arrangement of the diodes is such that the envelope of the full-wave detected IF signal is positive. However, if a negative envelope becomes necessary, it is sufficient to turn around the polarity of the diodes in the circuit. No low-pass filter is present between the outlet of the block RIV and the first input of the phase shifter SFAS.

The local oscillator signal output from the block SFAS is a signal represented by the function $\cos(\omega_{OL}t - \phi_{PD})$. The symbol $\phi_{PD}$ represents a phase shift introduced by the block SFAS on the signal OL. More precisely the phase of the signal OL is changed in accordance with the envelope of the IF signal detected. The sign - indicates that the phase is delayed and, as better illustrated below, this depends on the positive sign preselected for the envelope voltage.

The converter CONV uses the signal $\cos(\omega_{OL}t - \phi_{PD})$ to convert to radiofrequency the signal $aV_m\cos(\omega_{IF}t)$ obtaining at the output a signal $cV_m\cos(\omega_{RF}t - \phi_{PD})$. The frequency $f_{RF} = \omega_{RF}/2\pi = f_{OL} \pm f_{IF}$ is the center-band frequency of the RF signal which, in the transmitter of the example, falls within an operative range between 18GHz and 19GHz.

The block CONV of FIG. 1, as already said, represents a converter in the most general case. In the predistorter of the example, the converter being of the subharmonic type, the converted signal is $cV_m\cos(\omega_{RF}t - 2\phi_{PD})$. In this case the RF signal is obtained starting from a local oscillator frequency $f'_{OL}$ = 1/2 $f_{OL}$ included in a range of frequencies extending from 9GHz to 9.5GHz.

The signal $cV_m\cos(\omega_{RF}t - \phi_{PD})$ at the output of the block CONV of FIG. 1 is amplified by the block AMP3 whose output is the signal RF = $dV_m\cos$-$(\omega_{RF}t - \phi_{PD} + \phi_D)$. The symbol $\phi_D$ represents an added phase shift introduced, because of the AM/PM conversion, by the FET amplifier on the amplified signal. Said phase shift has a trend in time which depends on the instantaneous amplitude of the modulating signal transiting in the FET. The + sign means that the phase is leaded. The behaviour described is also deducible from the analysis of the output characteristics of a generic FET given in ordinary electronics text books. Said characteristics show that for an input signal power greater than a certain value and depending on the type of FET used, the output signal power departs from a linear trend and correspondingly the phase shift of the amplified signal also increases considerably.

The amplifier AMP3 uses the FET FLR 106 manufactured by Fujitsu and capable of delivering a saturation power of 28.4dBm. It is useful to recall that the average power level of a 16 QAM modulated RF signal is 6.5dB below peak power. At the highest amplification values the input signal power peaks of AMP3, if an appropriate compensation does not intervene, pilot the FET near saturation, causing amplitude and phase distortion which can reach 15 degrees in the entire RF signal band.

As regards compensation of the AM/AM conversion, in the AMP3 block is included a gain linearizer similar to that described in Italian patent application N. 19975 mentioned above.

As concerns compensation for the AM/PM conversion, it is actuated by the phase predistorter which is the object of the present invention. The law of compensation is such that during conversion of the IF signal to radiofrequency there is introduced on the converted signal an instantaneous phase variation equal and of opposite sign to that introduced by the FET by the effect of the AM/PM conversion.

The perfect compensation is reached when the condition - $\phi_{PD}(t)$ + $\phi_D(t)$ = 0 is verified at each instant $\underline{t}$, which is easier to achieve when the devices$^-$ which actuate said mutually opposite phase variations are of the same type and are piloted by the same signals. In the case of the example said conditions are verified. Indeed, the devices are two FET of the blocks SFAS and AMP3 respectively. The signal which pilots the phase variation of the FET of SFAS is the envelope of the IF signal full-wave detected which reaches the control input of said block. What causes the phase variation of the FET of AMP3 is the distortion signal generated by said FET at the high power levels of the signal at its input. Under these conditions the FET is piloted near saturation and the wave form of the amplified signal is compressed. The distortion signal has a trend correlated with that of the envelope of the detected RF signal amplitude-modulated by the base band signal. In view of the foregoing, it is seen that the distortion and predistortion phase signals have similar envelopes and average values which can be made to coincide by acting on the ATT attenuator.

FIG. 2 shows the module and phase response curves of the transistor FET MGF 1302 manufactured by Mitsubishi and used as a phase shifter in the block SFAS.

The responses were evaluated for different values of the polarization current IDS and hence of gate-source voltage VGS while holding constant the gate-source voltage VDS. More precisely, the curve 1 represents the trend of the relative phase $\underline{z}$ of a sinusoidal test signal having frequency $f_{OL}$ depending on the polarization voltage VGS. The curves 2, 3, 4 and 5 represent the power Pout of an output test signal for different values of power Pin of said input signal with variations in the polarization conditions. These curves therefore represent the behaviour of the gain of the FET with the variation of the polarization current $I_{DS}$ and therefore of the voltage $V_{GS}$.

As may be seen the gain remains almost constant for values of $V_{GS}$ between -0.3V and -0.85V, i.e. for currents IDS between approximately 0.9 and 0.3 $I_{DSS}$, which is the maximum value deliverable. In this range the phase $\underline{z}$ varies by no less than 25 degrees, which is therefore more than sufficient to compensate the maximum phase distortion of the signal RF which, as mentioned above, was 15 degrees reduced to approximately 7 because the converter is subharmonic.

It is recalled that the use of a FET transistor to provide a variable phase-shifter was described in the text of Italian patent application N. 19975 filed 9 April 1990 in the name of the same applicant.

More precisely, in said application there was claimed a predistortion linearizer for a final microwave power amplifier subject to gain compression and phase distortion characterized in that it comprises:

a first underpolarized FET transistor constituting a gain expander stage with the increase in the power of the signal at its input;

a phase shifter element controlled by the direct component of the voltage present at the output of said first transistor which introduces a phase distortion which compensates that of said final power amplifier;

wherein said phase shifter being an amplifier stage placed downstream of said gain expander consisting of a second FET transistor in common source configuration whose input is direct coupled with the output of said first transistor.

In the illustration of the nonlimiting example it was specified that by varying the direct component of the voltage $V_{GS}$ of the FET there is obtained a variation of the direct component of the drain current $I_{DS}$ which does not cause appreciable variation of the gain of the FET, since it is under linear operation conditions, but the value of the source carrier capacity $C_{GS}$ of the FET. The result is a variation of the output signal phase. There is also provided the capability of predetermining the signal of said phase variation.

Analogously in the compensation circuit in accordance with the present invention the FET of the block SFAS is polarized in class A with, for example, a VGS of 0.6V. The envelope voltage of the IF signal modulated by the base band signal full-wave detected, taken with the positive sign, is added to the polarization voltage $V_{GS}$. The resulting increase in instantaneous values of $V_{GS}$ causescorrespondingly a decrease in the values of the phase z̄ which compensates the increase introduced by the FET of AMP3.

A last advantage of the predistorter which is the object of the present invention is that its circuitry configuration allows use of the insensitivity of the frequency converters upon the variations of the local oscillator signal level. Therefore the spurious amplitude modulations introduced by the phase shifter SFAS on the local oscillator signal OL do not strike the radiofrequency signal RF.

**Claims**

1. Process for the compensation of the phase distortion due to the conversion of amplitude modulation into phase modulation (AM/PM), otherwise introduced by an amplification device in a radiofrequency amplified signal, characterized in that:

   a local oscillator signal (OL) is phase modulated according to a modulation law represented by the detection envelope of an intermediate frequency signal modulated by a base band signal;

   and in that the phase modulated local oscillator signal is used to convert to radiofrequency said intermediate frequency signal to obtain by the effect of said modulation law and the synchronism between the phase modulation and conversion operations a radiofrequency signal (RF) also phase modulated according to the same law, whose phase undergoes an instantaneous variation (- $\phi_{PD}$) equal and opposite to that (+ $\phi_D$) introduced by the radiofrequency amplification device (AMP3).

2. Compensation process in accordance with claim 1 characterized in that the detection envelope of said intermediate frequency signal (IF) is a full-wave detection envelope.

3. Circuit for the compensation of the phase distortion due to the conversion of amplitude modulation in phase modulation (AM/PM) otherwise introduced by the amplification device in a radiofrequency amplified signal, characterized in that it comprises:
   - a controllable phase shifter (SFAS) to which arrive a local oscillator signal (OL) and a signal which controls a phase variation (- $\phi_{PD}$) of said local oscillator signal (OL) able to compensate the distortion (+ $\phi_D$) introduced by the amplification device (AMP3);
   - a detector circuit (RIV) for an intermediate frequency signal (IF) modulated by a base band signal, the detected signal controlling the phase variation (-$\phi_{PD}$) of the local oscillator signal (OL); and
   - a frequency converter circuit (CONV) which converts said intermediate frequency signal (IF) to a frequency ($f_{RF}$) equal to or a multiple of that of the local oscillator signal coming from the phase shifter (SFAS), the converted signal being said radiofrequency amplified signal (RF).

4. Circuit for the compensation in accordance with claim 3, characterized in that said detector (RIV) of the intermediate frequency signal (IF) is a full-wave detector.

5. Circuit for the compensation in accordance with claim 3, characterized in that said frequency converter circuit (CONV) is of the subharmonic type.

6. Circuit for the compensation in accordance with claim 3, characterized in that said frequency converter circuit (CONV) is of the image suppression type.

7. Circuit for the compensation in accordance with claim 3, characterized in that said frequency converter circuit (CONV) is both of the subharmonic and image suppression type.

FIG. 1

FIG. 2

EP 0 522 525 A1

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | EP-A-0 047 825 (LICENTIA PATENT-VERWALTINGS-GMBH) <br> * page 1, line 6 - line 15 * <br> * page 2, line 5 - line 7 * <br> * page 3, line 15 - line 36 * <br> * page 7, line 11 - line 26 * <br> * page 7, line 31 - line 33 * <br> * page 8, line 1 - line 10; figures 4,5 * | 1-4 | H03C1/04 <br> H03F1/32 <br> H03D7/00 |
| A | PATENT ABSTRACTS OF JAPAN <br> vol. 4, no. 170 (E-35)(652) 22 November 1980 <br> & JP-A-55 118 212 ( NIPPON DENKI K. K. ) 11 September 1980 <br> * abstract * | 1-4 | |
| | | | TECHNICAL FIELDS SEARCHED (Int. Cl.5) |
| | | | H03C <br> H03F <br> H03D |

The present search report has been drawn up for all claims

| Place of search | Date of completion of the search | Examiner |
|---|---|---|
| THE HAGUE | 13 OCTOBER 1992 | BUTLER N.A. |